Europäisches Patentamt

European Patent Office

Office européen des brevets

(11) Publication number:

0 346 131
A2

# EUROPEAN PATENT APPLICATION

(21) Application number: 89305828.9

(22) Date of filing: 09.06.89

(51) Int. Cl.⁴: **H 01 J 37/32**

(30) Priority: 09.06.88 JP 142629/88

(43) Date of publication of application:
13.12.89 Bulletin 89/50

(84) Designated Contracting States: DE FR GB

(71) Applicant: ANELVA CORPORATION
8-1 Yotsuya 5-chome
Fuchu-shi Tokyo 183 (JP)

(72) Inventor: Tsukada, Tsutomu c/o Anelva Corporation
8-1 Yotsuya 5-chome, Fuchu-shi
183 Tokyo (JP)

Tamaki, Toshio c/o Anelva Corporation
8-1 Yotsuya 5-chome, Fuchu-shi
183 Tokyo (JP)

Yoshida, Tatsuhiko c/o Anelva Corporation
8-1 Yutsuya 5-chome, Fuchu-shi
183 Tokyo (JP)

(74) Representative: Crisp, David Norman et al
D. YOUNG & CO. 10 Staple Inn
London, WC1V 7RD (GB)

(54) Dry etching apparatus.

(57) A dry etching apparatus comprising a vacuum chamber provided therein with an RF electrode. On the RG electrode at least one object substrate is placed. The RF electrode is covered with a substrate beds and detachable dielectric members. The substrate beds comprise a dielectric portion and a conductive portion provided just under the dielectric portion. The conductive portion is equipotential in terms of direct current to the RF electrode. A passageway comprising a gaps between the dielectric members, gaps between the dielectric members and the substrate beds, etc. extends from the surface of the RF electrode to the plasma space. The passageways are so crooked in cross section perpendicular to the RF electrode that the plasma space can not struturally be viewed from the surface of the RF electrode. To the RF electrode is applied a negative DC voltage having larger absolute value that that of a negative self-bias voltage at the object substrate induced by plasma discharge.

FIG. 3

Description

# DRY ETCHING APPARATUS

This invention relates to a dry etching apparatus particularly but not exclusively for etching substrates such as silicon substrates for producing semiconductor integrated circuits using a gas plasma generated by radiofrequency glow discharge.

Dry etching apparatus for etching object substrates (hereinafter referred to in brief as "substrates") using radiofrequency glow discharge, are widely used in the field of production of semiconductor integrated circuits. This dry etching apparatus usually has a structure comprising a vacuum chamber provided with an RF electrode, to which a radiofrequency voltage can be applied, and with an earthing electrode, and between the earthing electrode and the RF electrode a plasma can be generated. Various etching systems are employed in dry etching apparatus, including reactive ion etching (RIE) apparatus, in which etching is effected by placing a substrate on an RF electrode, which has increasingly been used in various processes for producing semiconductor devices since it is capable of anisotropic etching and excellent for use in mass production.

Conventional RIE apparatus has a structure in which an object substrate, having an etching mask made of a photoresist, is simply placed on an RF electrode (or a substrate bed disposed thereon). This structure allows the substrate to be easily heated by a plasma to a high temperature, which results in thermal damage to the photoresist of the etching mask and deterioration of the etching pattern. Therefore, this structure has the disadvantage that difficulties are experienced in improving the etching rate and controlling the etching pattern as desired.

In view of the above, methods have been proposed of keeping the temperature of a substrate low during an etching treatment, which include a method wherein a substrate is mechanically clamped on an RF electrode (or a substrate bed disposed thereon) to improve the thermal contact therebetween thereby keeping the temperature of the substrate low, a method wherein a gas such as helium flows inbetween the reverse surface of a substrate and the upper surface of a substrate bed to enhance the effect of heat dissipation from the substrate, and a method wherein a DC electrode is provided under a substrate bed or an RF electrode which is used to produce an electrostatic force which brings the substrate into close contact with the substrate bed or the RF electrode (electrostatic chucking) in order to improve the heat transfer. In particular, since this electrostatic chucking method involves a relatively simple structure and provides a large cooling effect, various systems for achieving electrostatic chucking have been proposed.

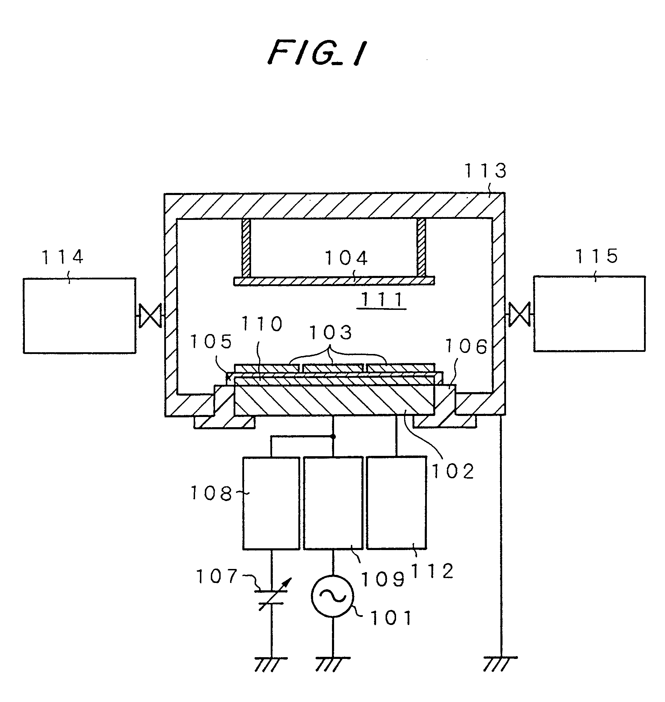

For example, Japanese Patent Publication No. 53,853/1981 (Japanese Patent Laid-Open No. 90,228/1980) discloses a "dry etching apparatus" in which the electrostatic chucking method is employed and which uses the electrical conductivity of a gas plasma. According to this conventional system, an RF electrode and a gas plasma serve as electrodes sandwiching a dielectric film which not only makes the system simple but also minimizes damage to a substrate. Furthermore, according to this system an electrostatic chucking force is present only when the gas plasma is generated and so so facilitates chucking and unchucking of the substrate. Thus, this system for electrostatic chucking is very effective. Fig. 1 of the accompanying drawings is a schematic cross-sectional view of the structure of this known dry etching apparatus. The structure shown in Fig. 1 comprises a radiofrequency power source 101, an RF electrode 102, substrates 103, a counter electrode 104, and a dielectric film 105 on which the substrates 103 to be electrostatically chucked are placed. The structure shown in Fig 1 further comprises an insulator 106, a DC power source 107, a radiofrequency cutoff circuit 108, a radiofrequency matching circuit 109, a conductive rubber sheet 110 provided on the RF electrode 102, a plasma 111, a cooling system 112 for the RF electrode 102, a vacuum chamber 113, a pumping system 114, and a gas feed system 115. The above-mentioned components 101 to 115 of the structure are known in the art, and hence are not described in detail.

However, various problems arose when etching was effected with dry etching apparatus of the kind described above. In the case of a batch type dry etching apparatus comprising an HF electrode 102 having an upper surface increased in area for the purpose of carrying out a blanket etching treatment of a plurality of substrates and a conductive rubber sheet 110 provided all over the broad upper surface of the HF electrode 102, great difficulty is encountered in covering the entire surface, exposed in a vacuum chamber 113, of the rubber sheet 110 with a dielectric film 105 in such a way as to bring the latter into perfect close contact with the former without leaving spaces therebetween. Even if the entire surface of the rubber sheet 110 can be covered with the dielectric film 105 without leaving spaces therebetween, small spaces develop between the dielectric film 105 and the rubber sheet 110 when the vacuum chamber 113 is evacuated to a high vacuum. When a plasma is generated, abnormal discharge occurs in these small spaces which not only gives rise to a failure in producing electrostatic chucking but also destroys the dielectric film 105 and/or the DC power source 107 used for electrostatic chucking.

Usually, a substrate 103 is electrostatically chucked by an electrostatic force produced by a potential difference between a negative self-bias voltage of say several hundred volts V induced in the substrate 103 during etching and a DC voltage applied to an RF electrode 102 and hence to a conductive rubber sheet 110 provided thereon. Accordingly, a positive DC voltage of about 1 kV is applied from a DC power source 107 to the RF electrode 102. The aforementioned abnormal discharge results from such an applied voltage of about 1 kV, which, during plasma discharge, forces electrons in a plasma to flow through the small spaces as mentioned above into the RF electrode 102 to cause the abnormal discharge.

Even when the DC voltage for electrostatic chucking is reversed from a positive one to a negative one, such abnormal discharge still occurs. In this case, ions flow into the above-mentioned small spaces.

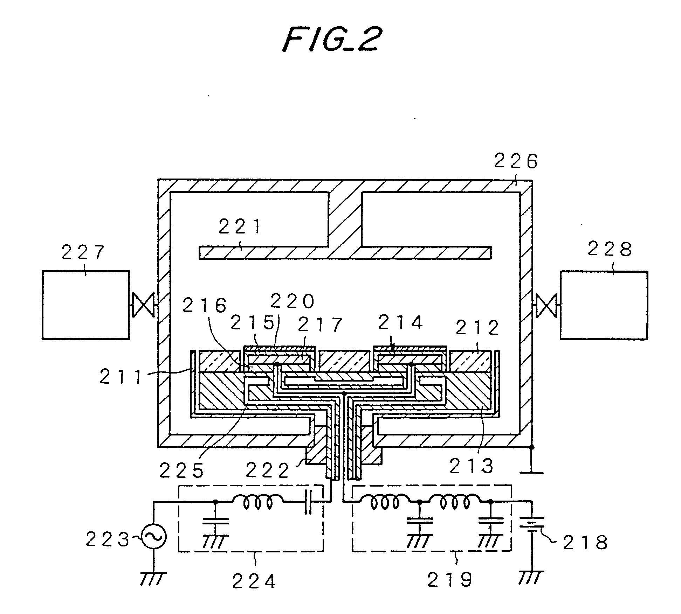

In order to avoid the occurrence of such discharge, the applicants of the present invention have proposed an apparatus as shown in Fig. 2 (Japanese Patent Laid-Open No. 149,704/1982). In this apparatus, a plurality of substrate beds 214 are provided on an RF electrode 213 having a surface covered indirectly with a shield panel 211 and directly with a dielectric electrode cover 212. Electrodes 217 each covered with a dielectric film 215 and insulated from the RF electrode 213 with a dielectric 216 provided therebetween are embedded just under the corresponding substrate beds 214. A DC voltage is applied from a DC power source 218 through a radiofrequency filter 219 only to these electrodes 217. The apparatus further comprises substrates 220, a counter elctrode 221, an insulator 222, a radiofrequency power source 223, a radiofrequency cutoff circuit 224, a cooling system 225, a vacuum chamber 226, a pumping system 227, and a gas feed system 228. The foregoing apparatus has the disadvantage not only in that difficulty is experienced in the wiring for DC voltage application, but also in that the etching characteristics for the substrates 220 vary from substrate to substrate because of the influences thereon of slight structural differences and the like between the plurality of the substrate beds 214 provided on the HF electrode 213 as shown in Fig. 2.

Furthermore, in both types of conventional apparatus, having the aforementioned structures as shown in Figs. 1 and 2, even if the electrodes 110, 217 can be covered with the dielectric films 105, 215 in perfect close contact relation, the dielectric films 105, 215 deteriorate during dry etching over long periods of time. This requires the frequent exchange of the dielectric films 105, 215 for new dielectric films, which gives rise to an additional problem of the large loss of time and labour needed for such an exchange. Even when the dielectric films 105, 215 are adhered to the electrodes 110, 217, whether or not the adhesion of the dielectric films 105, 215 to the electrodes 110, 217 can withstand practical use cannot be predicted before an actual trial of a dry etching operation in vacuo, and the probability of successful adhesion is low. Therefore, problems are associated with adopting these dry etching apparatus in actual large-scale integrated circuit production lines.

The present invention seeks to solve the above-mentioned problems. Accordingly, the present invention aims to provide a novel dry etching apparatus wherein a substrate bed(s) having a comparatively simple structure and dielectric members are assembled into an HF electrode structure capable of sufficiently strongly electrostatically chucking a substrate(s) on the substrate bed(s) and at the same time stably and sufficiently cooling the substrate(s) during dry etching to thereby effect the etching of the substrate(s) with excellent uniformity and reproducibility.

According to the present invention there is provided a dry etching apparatus comprising a vacuum chamber equipped with means for introducing a gas into the vacuum chamber and provided with an RF electrode, to which a radiofrequency voltage is appliable and on which at least one object substrate(s) is placed, and with a earthed electrode between which and said RF electrode a plasma of said gas is to be generated for etching said substrate(s);

(a) wherein the entire suface of said RF electrode, which faces said plasma is covered with at least one substrate bed(s) and detachable dielectric members;

(b) wherein said substrate bed(s) comprises a dielectric portion having a surface on which said substrate is to be placed and a conductive portion provided under said dielectric portion and being equipotential in terms of direct current to said RF electrode;

(c) wherein at least one passageway(s) comprising at least one gap(s) between said dielectric members, a gap(s) between said dielectric members and said substrate bed(s), and extending from said facing surface of said RF electrode to the plasma space is so crooked when viewed in cross section perpendicular to said RF electrode that said plasma space cannot be structurally viewed from said facing surface of said RF electrode; and

(d) wherein said RF electrode is provided with means for applying thereto through a radiofrequency filter a negative DC voltage having a larger absolute value than that of a negative self-bias voltage at said object substrate(s) induced by plasma discharge during radiofrequency power supply.

In the dry etching apparatus of the present invention having the foregoing structure, since the conductive portion(s) (i.e., the main body (bodies) of the substrate bed(s)) surrounded by the dielectric portion(s) serves as an electrostatic chucking electrode(s) which is equipotential in terms of direct current to the HF electrode, no particular lead wire or the like for applying therethrough a DC voltage to the main body (bodies) of the substrate bed(s), as the elctrostatic chucking electrodes, are needed. Accordingly, it will suffice to apply a DC voltage for electrostatic chucking directly to the HF electrode. This permits the structure of the dry etching apparatus to be simplified.

Furthermore, since the value of ionic current is characteristically saturated at a low level no matter how high the absolute value of the negative DC voltage applied to the HF electrode may be raised, a sufficiently high voltage can be applied, through the dielectric portion(s), between the substrate(s) and the conductive portion(s) positioned just under the dielectric portions of the substrate bed(s) to make a large electrostatic chucking force available.

In addition, attraction between the substrate(s) and the substrate bed(s) occurs only during a dry etching operation just as in the case of conventional apparatus which facilitates attachment and detachment of the substrate before and after, respectively, the dry etching operation.

The structure of the dry etching apparatus of the present invention does not allow "electrons" to flow in direct current fashion or mode from the plasma into the HF electrode because not only is the surface of the HF electrode perfectly covered with the detachable dielectric members and the substrate bed(s) having a dielectric portion having a surface for placing thereon a substrate while passageway(s), or gap continuum(s), comprised of a gap(s) between the dielectric members, and a gap(s) between the dielectric members and the substrate bed(s), etc. is crooked in cross section perpendicular to the RF electrode, but also because the negative DC voltage having a larger absolute value then that of the negative self-bias voltage induced in the substrate(s) during discharge is applied to the HF electrode.

Although "ions" instead of electrons flow into direct current fashion into the HF electrode, the amount of ionic current flowing into it is extremely suppressed because the passageway(s) which can be path(s) for the ions are crooked in cross section perpendicular to the RF electrode. The extent of such suppression is far larger than that occurring in the case of electric current. This suppressive effect increases as the number of bends in the passageways increases. Even if a flow of ions into the HF electrode occurs, the amount of ionic current flowing thereinto is suppressed to at most a few mA/cm² as will be described later. The influence of such a slight amount of leakage current on a power source for electrostatic chucking hardly affects the self-bias voltage during dry etching.

In a preferred embodiment when attachable and detachable dielectric ring(s) having a smaller inner circumference and a larger circumference than the outer circumference of a substrate is fitted around the protruding portion(s), if provided, of the substrate bed(s) on which the substrate(s) is placed, particularly the very thin dielectric portion(s), or film(s), (for electrostatic chucking) constituting the upper surface portions(s) of the substrate bed(s) is prevented from being etched and hence being shortned in life span, and the ring(s) also facilitates obtaining a plurality of bends in the passageway(s).

Various preferred features and embodiments of the invention will now be described by way of non-limiting example with reference to the accompanying drawings, in which:

Figs. 1 and 2 show cross-sectional views of conventional dry etching apparatus;

Fig. 3 is a schematic cross-sectional view of one embodiment of a reactive ion etching apparatus of the present invention;

Fig. 4 is a graph showing a probe-in-plasma voltage electric current characteristic curve;

Fig. 5 shows a schematic diagram of an apparatus for making a measurement to obtain the graph of Fig. 4;

Fig. 6 shows a cross-sectional view of a structure, around a substrate bed, of another embodiment of the dry etching apparatus of the present invention;

Fig. 7(a) shows a cross-sectional view of a trench formed by silicon trench etching with an embodiment of the dry etching apparatus of the present invention; and

Fig. 7(b) is a cross-sectional view of a trench formed by silicon trench etching with the same apparatus as used in the formation of the trench of Fig. 7(a), but without effecting electrostatic chucking.

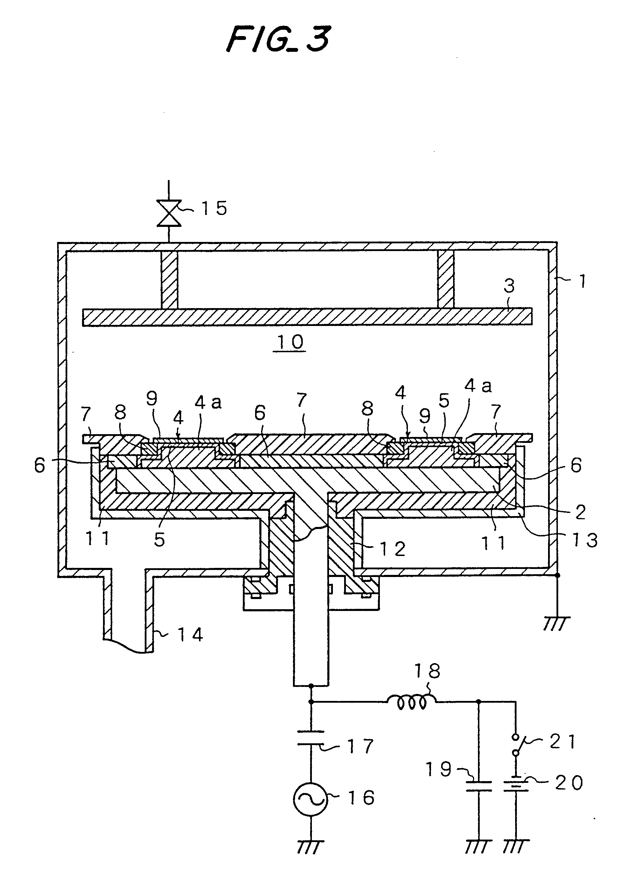

Fig. 3 shows a reactive ion etching apparatus of a parallel flat plate type. This apparatus comprises an earthed vacuum chamber 1 wherein an RF electrode 2 and an earthed vacuum chamber 1 wherein an RF electrode 2 and an earthed counter 3 are disposed in such a way as to have the respective electrode surfaces thereof parallel with each other.

A plurality of the main bodies 4a of convex substrate beds 4 which bodies are made of aluminum are mounted on the upper surface of the HF electrode 2. Object substrates 9 to be subjected to an etching treatment are placed on the upper surfaes of the protruding portions of the convex substrate beds 4 to cover the protruding portions. The areas of the upper surfaces of the protruding portions are smaller than those of the substrates 9 so that the protruding portions are completely covered by the substrates 9.

The bottom surfaces of the main bodies 4a of the substrate beds 4 are in direct (also electrical) contact with the HF electrode 2. The surfaces of the main bodies 4a of the substrate beds 4 other than the bottom surfaces are totally covered with a polyimide film 5 having a thickness of 25 μm. In this embodiment, the substrate beds 4 comprise main bodies 4a and the respective polyimide films 5. Accordingly, the substrates 9 are, in effect, placed on the polyimide films 5.

The upper surface of the HF electrode 2 except for the areas thereof in contact with the substrate beds 4 is covered with dielectric members, namely in this embodiment a first dielectric cover 6 and a second dielectric cover 7. The two dielectric covers 6 and 7 as well as the substrate beds 4 can be easily detached from the HF electrode 2 by raising them. In other words, they are attachable to and detachable from the HF electrode 2 so as to provide a construction which is easy to assemble and dismantle.

Dielectric rings 8 as further dielectric members are fitted around the protruding portions of the substrate beds 4. The peripheral portions of the substrates 9 other than those in contact with the substrate beds 4 are positioned on the dielectric rings 8. Also, the dielectric rings 8 are attachable to and detachable from around the protruding portions of the substrate beds 4 having the respective main bodies 4a covered with the polyimide films 5. The detachment of the dielectric rings 8 can be easily achieved by pulling them upwards. The inner diameters of the dielectric rings 8 are a little smaller than the diameters of the substrates 9, while the outer diameters of the dielectric rings 8 are a little larger than the diameters of the substrates 9. Accordingly, when assembly of the apparatus is complete and the substrates 9 are placed on the substrate beds 4, the polyimide films 5 of the substrate beds 4 are completely covered with the corresponding substrates 9, dielectric rings 8, and first and second dielectric covers 7 and 8.

Passageways are left when the first and second dielectric covers 6 and 7, the dielectric rings 8, and the substrate beds 4 are assembled together which have at least two bends in them when viewed cross-sectionally (four bends in Fig. 3) providing a structure in which a space 10 in which the plasma is generated cannot be viewed directly from the HF electrode 2. Each passageway extends from the upper surface of the HF electrode 2 to the plasma space 10 and includes a gap between the dielectric cover 6 and the polyimide film 5, a gap between the dielectric covers 6 and 7, a gap between the dielectric ring 8 and the polyimide film 5, and a gap between the substrate 9 and the dielectric ring 8. Since the substrate beds 4 are convex, the passageways comprising those gaps run, not straight, but crooked from the upper surface of the HF electrode to the plasma space 10 as shown in Fig. 3.

The side face and reverse surface fo the HF electrode 2 are covered with a shield panel 13 with dielectric spacers 11 and 12 provided therebetween, which are not required to be detachable.

A description will now be made of how to operate the apparatus of this embodiment having the foregoing structure, in the case of silicon trench etching in which fine grooves and/or holes are formed in a silicon substrate. The vacuum chamber 1 is evacuated to a high degree of vacuum by means of a vacuum pump (not shown in Fig. 3) connected with an evacuation pipe 14. Subsequently, a gas feed valve 15 is opened to feed a gas containing $SiCl_4$ into the vacuum chamber 1 until the pressure therein is raised to 15 mTorr.

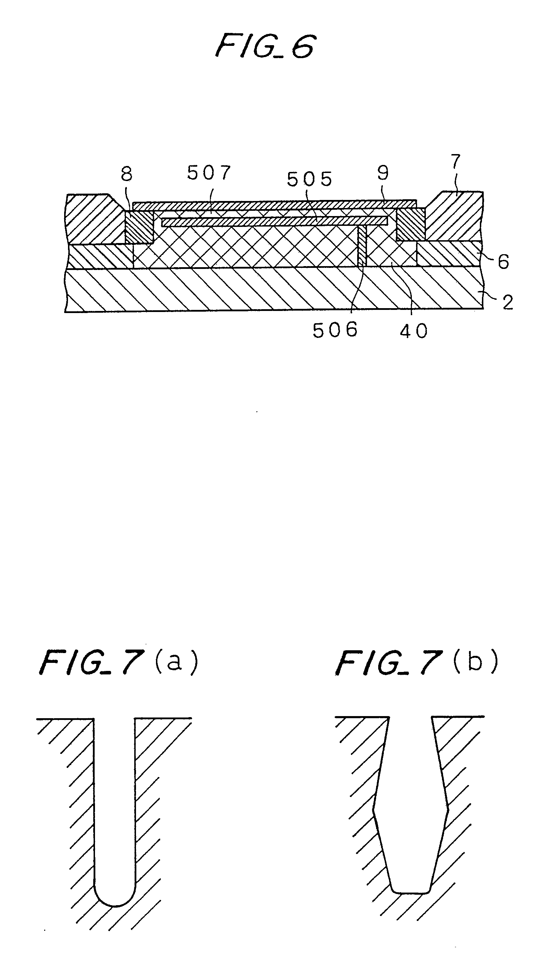

While cooling the HF electrode 2 by circulating a cooling medium (while not shown in Fig. 3, the structure shown in Fig. 6 can be used for effecting the cooling), a radiofrequency power of 13.56 MHz and 1,000 W is supplied from a radiofrequency power source 16 through a blocking condenser 17 to the HF electrode 2. A switch 21 is turned on to apply a negative DC voltage of 2 kV from a DC power source 20 through a high-frequency filter comprising a coil 18 and a condenser 19 to the HF electrode 2 simultaneously with the supply of the radiofrequency power.

The supply of the radiofrequency power causes discharge through the gas containing $SiCl_4$ generating a plasma in the plasma space 10. This gives the substrates 9a negative self-bias voltage of about 500 V (having an absolute value lower than that of the above-mentioned negative DC voltage), by which ions are attracted from the plasma to the substrates 9, which are subjected to reactive ion etching (RIE) through an interaction of those ions and active radicals formed by the plasma with the substrates 9.

As a result, a potential difference arises between the substrates 9 and the main bodies 4a of the substrate beds 4 with the polyimide films 5 of 25 μm in the thickness sandwiched therebetween.

When the negative DC vltage applied from the DC power source 20 to the HF electrode 2 is increased in absolute value to say about 1.5 kV which is a negative DC voltage and is about 1 kV more negative than the negative self-bias voltage (say about 500 V) induced in the substrates 9, the substrates 9 are electrostatically attracted more tightly to the substrate beds 4 so that the substrates 9 can be efficiently cooled due to heat dissipation therefrom through the substrate beds 4 to the HF electrode 2.

Since the potential of the HF electrode 2 and the main bodies 4a of the substrate beds 4 is considerably more negative than the self-bias potential, no "electronic current" flows through the gaps between the dielectric members 6, 7 and 8 and between the substrate beds 4 and the dielectric members 6, 7 and 8 which are assembled together so as to cover the upper suface of the RF electrode 2. Therefore eliminating the dielectric breakdown of the dielectric portions 5 and the dielectric members, which would otherwise occur, caused by an excessive electronic current as in the conventional apparatus.

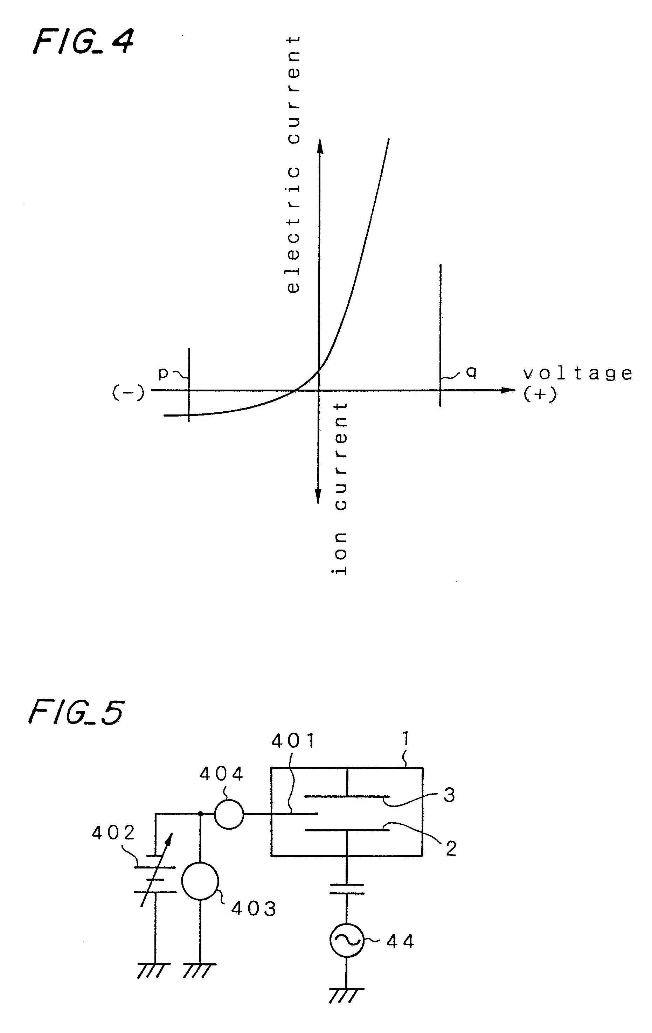

Instead, however, ions in the plasma flow through the above-mentioned gaps into the HF electrode 2. As shown in the probe-in-plasma characteristic curve of Fig. 4 (the details of which will be described later), such an "ionic current" is saturated at a level of one several-hundredth to one several-thousandth of an electronic current at a voltage in operation (in Fig. 4, "p" refers to a voltage of ionic current during operation of this embodiment of the present invention, while "q" refers to the voltage of the electronic current during operation of the conventional apparatus). Therefore, the dielectric portions and the dielectric members do not undergo dielectric breakdown, which would otherwise be caused by an overcurrent. Furthermore, the passageways which comprise the above-mentioned gaps between the dielectric members and between the substrate beds and the dielectric members, and which would otherwise allow the ionic current to pass therethrough is crooked to thereby reduce the flow therethrough of ionic current and prevent the occurrence therein of discharge. Moreover, it has been experimentally shown that the ionic current can be reduced to a negligible level when bends are provided in a plurality of places in each of the passageways.

The above-mentioned probe-in-plasma characteristic curve shown in Fig. 4 will now be described. It was drawn by plotting the readings of a voltmeter 403 and an ammeter 404 when the DC voltage applied from a power source 402 to a probe 401 was varied in an etching apparatus of parallel flat plate type as schematically illustrated in Fig. 5 wherein the probe 401 was inserted in a plasma generated by radiofrequency power supplied from a radiofrequency power source 44 in a space between an RF electrode 2 and a counter electrode 3 in a chamber 1.

As illustrated by the probe-in-plasma characteristic curve of Fig. 4, the electric current (ionic current) is saturated immediately in the region of negative probe voltages, and the electric current flowing into the probe at a voltage in operation ("p" in Fig. 4) is as low as about one several-hundredth to one several-thousandth of that (electronic current) at a voltage in operation ("q" in Fig. 4) in the region of positive probe voltages. This phenomenon, which was experimentally found by the applicants of the present invention, is utilized in the present invention.

Fig. 6 is a front cross-sectional view of a structure, around a substrate bed 4, of another embodiment of the dry etching apparatus of the present invention. In Fig. 6, the same numerals as in Fig. 3 denote parts having the same functions as those of the parts in Fig. 3. Thus, a detailed description of such parts is omitted. In Fig. 6, numeral 40 refers to the substrate bed used in this embodiment.

A major part of the substrate bed 40 is made of a ceramic material and forms a dielectric member. A metallic film electrode 505 as a conductive portion is embedded in the substrate bed 40 under a substrate 9 at a depth of several tens to several hundreds μm from the upper surface of the substrate bed 40, and is electrically connected through a connecting conductor 506 running through a through-hole with an HF electrode 2. Therefore, again in this embodiment, the potential of the metallic film electrode 505 is the same in terms of direct current as that of the HF electrode 2. A ceramic portion between the substrate 9 and the metallic film electrode 505 forms a dielectric film portion 507.

A dielectric ring 8, and first and second dielectric covers 6 and 7 which are all detachable dielectric members are disposed around the substrate bed 40 to prevent the HF electrode 2 from being exposed to a plasma. The dielectric ring 8 having an inner diameter smaller than the diameter of the substrate 9 and an outer diameter larger than the diameter of the substrate 9 is disposed around the periphery of the protuding portion of the substrate bed 40 to protect the dielectric film portion (ceramic) 507 which is a very thin surface portion of the substrate bed 40 on the upper side of the metallic film electrode 505, to thereby prolong the life span of the dielectric film portion 507.

Figs. 7(a) and 7(b) show cross-sectional contours of trenches of 1.0 μm in width and 4.5 um in depth formed by etching silicon substrates, each having thereon an $SiO_2$ mask, by means of a dry etching apparatus. Fig. 7(a) is a reproduction diagram of a scanning electron microscope photograph of a trench formed by etching a silicon substrate using the apparatus of Fig. 3 according to the aforementioned embodiment of the present invention wherein the silicon substrate was attracted by electrostatic chucking to the substrate bed 4 cooled to 10°C. As illustrated in this diagram, the trench was formed without side etching to have an ideal shape having a vertical side wall and a round bottom. Fig. 7(b) is a reproduction diagram of a scanning electron microscope photograph of a trench formed by etching a silicaon substrate under substantially the same conditions as in the formation of the trench shown in Fig. 7(a) except for the nonuse of electostatic chucking. The trench had a shape having a recessed side wall, namely a so-called bowing shape. The latter etching method provides irregular trench shapes with large variation and is therefore unusable in practical production of VLSI devices.

While the foregoing embodiments are concerned with cases where the present invention is applied to a batch type apparatus wherein a plurality of substrates are subjected to one operation of an etching treatment, the application of the present invention is not limited only to such a batch type apparatus, but the present invention can, needless to say, be applied effectively to a one-by-one type apparatus wherein a single substrate is subjected to one operation of an etching treatment.

Needless to say, the material of the dielectric portion(s) or dielectric film(s) used in the present invention are not limited to a polyimide or a ceramic material, and anodized aluminum. Furthermore, aluminum or other conductive materials such as metal can be used as the material in the conductive portion(s) in the present invention. Also, the thickness of the dielectric portion(s) or dielectric film(s), the dielectric members, and the electrodes is not restrictive.

The application of the present invention is not limited to a reactive ion etching apparatus, and the present invention can be applied satisfactorily to other types of dry etching apparatus.

According to the present invention, dry etching can be effected while sufficiently strongly electrostatically chucking a substrate onto a substrate bed. Accordingly, sufficient cooling of the substrate can be efficiently effected while keeping the temperature of the substrate stable. This provides a dry etching apparatus capable of etching substrates with excellent uniformity and reproducibility.

## Claims

1. A dry etching apparatus comprising a vacuum chamber equipped with means for introducing a gas into the vacuum chamber and provided with an RF electrode, to which a radiofrequency voltage is appliable and on which at least one object substrate(s) is placed, and with a earthed electrode between which and said RF electrode a plasma of said gas is to be generated for etching said substrate(s);

(a) wherein the entire suface of said RF electrode, which faces said plasma is covered with at least one substrate bed(s) and detachable dielectric members;

(b) wherein said substrate bed(s) comprises a dielectric portion having a surface on which said substrate is to be placed and a conductive portion provided under said dielectric portion and being equipotential in terms of direct current to said RF electrode;

(c) wherein at least one passageway(s) comprising at least one gap(s) between said dielectric members, a gap(s) between said dielectric members and said substrate bed(s), and extending from said facing surface of said RF electrode to the plasma space is so crooked when viewed in cross section perpendicular to said RF electrode that said plasma space cannot be structurally viewed from said facing surface of said RF electrode; and

(d) wherein said RF electrode is provided with means for applying thereto through a radiofrequency filter a negative DC voltage having a larger absolute value than that of a negative self-bias voltage at said object substrate(s) induced by plasma discharge during radiofrequency power supply.

2. A dry etching apparatus as claimed in claim 1, wherein said passageway(s) is bent in a plurality of places in cross-section perpendicular to said RF electrode.

3. A dry etching apparatus as claimed in claim 1 or 2, wherein said substrate bed(s) has a protruding portion on which a substrate is to be placed, and around which a detachable dielectric ring having a smaller, inner circumference and a larger outer circumference than the circumference of said substrate is provided as a dielectric member.

4. A dry etching apparatus as claimed in any one of the preceding claims wherein said substrate bed(s) comprises a convex conductive portion and a dielectric portion provided on all surfaces of said convex conductive portion except for a surface in contact with said RF electrode.

5. A dry etching apparatus as claimed in any one of the preceding claims wherein said substrate bed(s) comprises a dielectric portion made of a ceramic material which forms the major structure thereof, and a conductive portion embedded in said major structure in the proximity of a surface thereof on which the substrate is to be placed and electrically connected to said RF electrode.

6. A dry etching apparatus according to any one of the preceding claims wherein said gas is a reactive gas.

7. A method for dry etching a substrate using an apparatus according to any one of claims 1 to 6.

## FIG. 1

# FIG_2

# FIG. 3

*FIG. 4*

*FIG. 5*

## FIG_6

## FIG_7 (a)    FIG_7 (b)